# EUROPEAN PATENT APPLICATION

(11) **EP 1 976 024 A1**
(43) Date of publication of application: **01.10.2008**
(21) Application number: 06842870.5
(22) Date of filing: 19.12.2006
(51) Int. Cl.: H01L 31/042

(54) **METHOD FOR SOLDERING TAB LEAD ON SOLAR BATTERY CELL**

(30) Priority: 06.01.2006 JP 2006001592; 15.05.2006 JP 2006135822
(71) Applicant: Nisshinbo Industries, Inc., Chuo-ku, Tokyo 103-8650 (JP)
(72) Inventor: KATAYAMA, Manabu, Okazaki-shi, Aichi 4448560 (JP); IRIE, Katsumi, Okazaki-shi, Aichi 4448560 (JP)
(74) Representative: Thinat, Michel
(86) International application number: PCT/JP2006/325266
(87) International publication number: WO 2007/077728

(57) **Abstract**

The present invention relates to the method for soldering the interconnector to the photovoltaic cell, in manufacturing the photovoltaic module, which makes it possible to significantly inhibit or almost eliminate the deformation of the photovoltaic cell due to heat of the soldering when soldering the interconnector (hereinafter, refer also to as "lead wire") to the photovoltaic cell (hereinafter, refer simply to as "cell") that forms the module.In the present invention, the interconnector positioned at the predetermined position of the photovoltaic cell is soldered by dissolving the solder. As the photovoltaic cell is entirely being heated under the heating atmosphere, the photovoltaic cell is cooled down slowly thereafter. In the present invention, even if the photovoltaic cell is thin, similar heating does not warp the photovoltaic cell.

## Description

### FIELD OF INVENTION

This invention relates to a method for soldering an interconnector to a photovoltaic cell, in the process of manufacturing a photovoltaic module, which makes it possible to significantly inhibit or almost eliminate deformation of the photovoltaic cell due to the heat of the soldering when soldering the interconnector (hereinafter, referring also to as "lead wire") to the photovoltaic cell (hereinafter, simply referring to as "cell") that forms the module.

### BACKGROUND OF THE INVENTION

Conventionally, in order to attach the interconnector to the photovoltaic cell, the interconnector is welded by solder which is previously coated to the interconnector and is thereafter cooled at room temperature so as to be soldered.
It has been known that if the interconnector is soldered to the photovoltaic cell, warp is resulted in the photovoltaic cell due to the difference of the coefficient of thermal expansion between the cell and the interconnector or the like.

The photovoltaic module technical field is recently making progress in the direction in which the thickness of the photovoltaic cell is reduced; thus, the warping of the cell side resulted by the soldering of the interconnector has become one of the important problems to be solved.

That is, for the conventional photovoltaic cell having sufficient thickness and strength in the cell itself, since a force generated by thermal strain intending to warp the cell side on the basis of the difference of coefficient of thermal expansion between the photovoltaic cell and the interconnector is also absorbed by the strength in the cell side, there is no resultant warp, and even if the warp is resulted no large warp can be resulted.
However, in the recent photovoltaic cell in which the cell itself is thinly formed, the cell tends to be deformed after soldering the interconnector, and the cell may be cracked in the case where the deformation occurs, as described above.
Further, if the photovoltaic cell, in which the warp is resulted, is processed to the photovoltaic module, the deformation such as the warp or the like is mechanically corrected right at the time of processing, the deformation forms a stress applied to the cell so as to cause a crack, and the crack can also be caused at the time of handling the photovoltaic cell, in which the deformation such as the warp or the like is resulted, to the next process.
The cost of the photovoltaic cells is extremely high in consideration of the cost of the entire photovoltaic module, and there are problems that the defect due to cracking not only causes reduction of the productivity but also increases the overall cost for the defective work.

On the other hand, since the soldering work of the interconnector is achieved by positioning the interconnector constituted by a fine, narrow metal wire, with respect to the cell on the cell so as to be soldered, the heating technique for dissolving the solder by pressing the interconnector by a bar-like or rod-like rigid pressing member is disclosed in patent documents 1 and 2; however, these prior arts mainly aim to position and fix the interconnector and do not describe anything about the warp of the cell resulted after the soldering of the thin photovoltaic cell is completed and warp prevention measures.

Accordingly, an object of the present invention is to provide a soldering method that does not warp a photovoltaic cell by heating for soldering an interconnector to the photovoltaic cell even if the cell is thin.
[Patent Document 1] Japanese Unexamined Patent Publication No. 11-87756
[Patent Document 2] Japanese Unexamined Patent Publication No. 2003-168811

### SUMMARY OF THE INVENTION

The soldering method of the present invention is made for the purpose of resolving the above-described problems and is characterized in the steps of positioning the interconnector at a predetermined position of the photovoltaic cell at the time of soldering the interconnector to the photovoltaic cell; holding the cell in a flat state while the cell is under the heating atmosphere in which the solder is dissolved; and simultaneously, tightly holding the interconnector and the photovoltaic cell.
Also, the present invention teaches the soldering method for the interconnector to the photovoltaic cell, which is characterized in that the interconnector is positioned on the photovoltaic cell and held flat; and under the heat atmosphere, in which the solder is dissolved while the interconnector is being held in the cell, the interconnector and the photovoltaic cell are heated overall so as to solder while tightly holding the interconnector against the photovoltaic cell.
Also, in the above-mentioned soldering method, it is possible to employ a configuration whereby the interconnector is soldered at a predetermined position on the photovoltaic cell by entirely heating the photovoltaic cell under the heating atmosphere so as to dissolve the solder and thereafter slowly cooling the photovoltaic cell.

In the method of the present invention, since the photovoltaic cell to be soldered is held flat, it is possible to effectively inhibit the warp, which may be resulted in the photovoltaic cell after soldering the interconnector, in advance. The retention of the interconnector allows the cell to be held flat by pressing and supporting the interconnector to the photovoltaic cell side at a plurality of points on the interconnector, which does not cause unevenness in welding in the soldering because the cell and the interconnector can be held in a tight state.
As the pressing means for the interconnector for this purpose, it is preferable to employ an elastic stick-shaped member.
Further, on the photovoltaic cell side, in order to prevent the warping, it is preferable to constrain and hold the cell flatly in a direction at least extending along the interconnector to be soldered on a carrier holder or both side-edges extending along the interconnector from both surfaces.
If the photovoltaic cell, which is held flat in the manner mentioned above in the soldering step, is supported in a lower surface of the cell by a surface-shaped member or a crosspiece-shaped member on the carrier holder of the cell, it is possible to more effectively achieve the warp prevention according to the method of the present invention.

According to the present invention, when soldering the interconnector to the photovoltaic cell, the soldering the interconnector is carried out by setting the cell and the whole of the interconnector arranged in the cell under the heating atmosphere capable of dissolving the solder and entirely heating under the heating atmosphere, thereby dissolving the solder.
In the above-mentioned soldering step, since the solder is dissolved in the mechanical flat holding state of the photovoltaic cell in which the whole of the interconnector is arranged, it is possible to effectively prevent the deformation (the warp) of the photovoltaic cell at the time of soldering.
Also, according to the soldering method of the present invention, the interconnector can be pressed at multiple points and intervals of the pressing support can appropriately be adjusted such that the interconnector does not move up from the cell at the time of soldering.
Accordingly, uneven solder welding and defects can be eliminated.
Further, according to the present invention, since the photovoltaic cell is slowly cooled after entirely heating the photovoltaic cell so as to dissolve the solder, the interconnector moves within the dissolving solder when the solder is solidified, even if the heat contraction difference exists between the photovoltaic cell and the interconnector.
Accordingly, the deformation (warp) due to the difference of coefficient of thermal expansion between the photovoltaic cell and the interconnector and the thermal strain due to temperature distribution can be effectively prevented.

### BRIEF DESCRIPTION OF THE DRAWINGS

Fig. 1 is a side cross sectional view schematically showing a soldering step executing a method of the present invention;

Fig. 2 is a perspective view of a carrier holder in which two interconnectors to be soldered are arranged in one photovoltaic cell in the embodiment 1;

Fig. 3 is a front cross sectional view of one row of the carrier holder in which the stick-shaped member having spring elasticity is arranged for pressing the interconnector in the embodiment 2;

Fig. 4 is a partially sectioned plan view of the carrier holder in Fig. 3 in the embodiment 2;

Fig. 5 is a front cross sectional view of one row of the carrier holder in the embodiment 3;

Fig. 6 is a front cross sectional view of one row of the carrier holder in the comparative example 1;

Fig. 7 is a front cross sectional view of one row of the carrier holder in the comparative example 2;

Fig. 8 is a front cross sectional view of one row of the carrier holder in the comparative example 3;

Fig. 9 is a front cross sectional view of one row of the carrier holder in the comparative example 4;

Fig. 10 is a front cross sectional view of one row of the carrier holder in the comparative example 6; and

Fig. 11 is a view of a basic configuration of the carrier holder used for the soldering method in the present invention.

### DETAILED DESCRIPTION OF THE PREFERRED EMBODIMENTS

Next, embodiments for the soldering method of the present invention are explained with examples of the embodiments and comparative examples with reference to the accompanying drawings and tables.

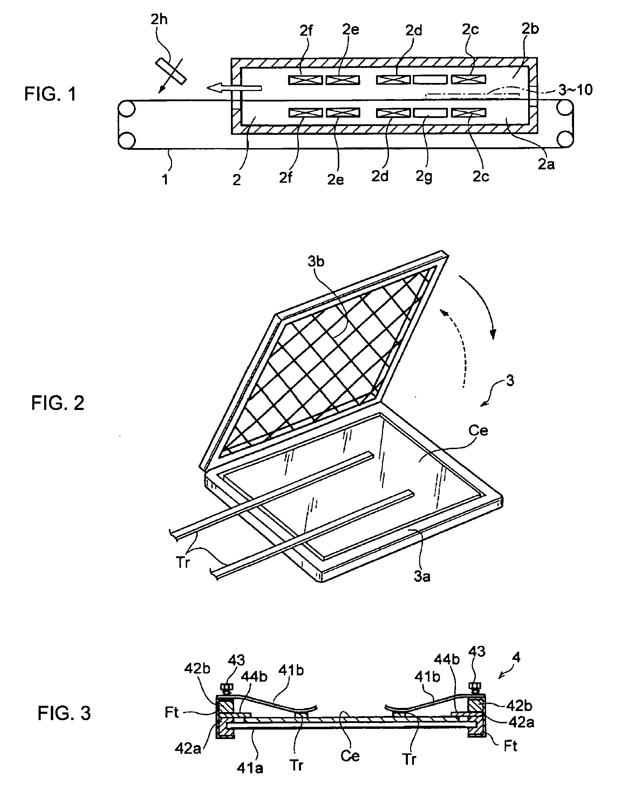

First, Fig. 1 is a side cross section view schematically showing the soldering steps conducted for finding the soldering method of the present invention. In the soldering step of Fig. 1, the soldering step is carried out by using a carrier conveyor 1. A photovoltaic cell Ce with two interconnectors Tr to be attached thereto is carried while holding the interconnectors Tr positioned by later described carrier holders 3 - 10. A heating space 2 is formed in such a manner that a carrier surface of the conveyor 1 travels in an inner portion of a chamber-shaped space arranged in such a manner as to overstride the conveyor 1 from upper and lower sides, and provided with a plurality of heating means (also called as heaters) in an inner portion thereof. [0023] The heating space 2 is formed in the following configurations. The heating space 2 is configured to be vertically dividable and is capable of opening and closing. The above-described carrier conveyor 1 is positioned at an intermediate position in a vertical direction of an upper chamber 2a and a lower chamber 2b. The carrier holders 3-10, which are holding cells Ce and interconnectors Tr, (not shown in Fig. 1,) together, run on the carrier conveyor 1. The carrier holders 3-10 are explained in detail later.

In the illustrated embodiment, four pairs of upper and lower heaters 2c, 2d, 2e and 2f are arranged in such a manner as to sandwich the conveyor 1 within a space formed by the chamber bodies 2a and 2b.

In the embodiment of the heating space 2 in Fig. 1, a heat reducing portion 2g (without a heater) without a heater arranged therein is positioned between the heaters 2c and 2d so as to have an appropriate distance in a moving direction. The temperature within the heating space 2, that is, the temperature of the heating atmosphere created by each of the heaters 2c - 2f may be set based on several factors such as the type and size of the photovoltaic cell Ce or size and materials of the interconnectors Tr. Also, in addition to setting of the entire interior of the heating space 2 to a uniform temperature, the interior of the heating space 2 may be configured such as to have the temperature difference along the carrier direction of the cell Ce holding the interconnectors Tr together by the carrier conveyor 1.

In Fig. 1, a cooling fan 2h is a slow cooling means arranged at an outlet side of the heating space 2.
Directivity can be given to solidification of the dissolved solder of the interconnector which is arranged at a predetermined position of the photovoltaic cell by adjusting temperature and the gas volume of air blown from the cooling fan 2h and conveyor speed of the carrier conveyor 1. More preferably, the slow cooling desirably progresses from one end of the photovoltaic cell Ce toward the other side in such a manner as to prevent the warp and deformation of the photovoltaic cell Ce caused by the contraction force of interconnectors Tr because the movement of the interconnectors Tr in the dissolved solder progresses from one direction. Accordingly, "slow cool" in the present invention means phenomenon, contracting the interconnectors Tr within the solder and reducing a pulling force applied to the cell on the basis of the contraction of the interconnectors Tr while solidering is in progress as gradually cooling down.
In this case, the slow cooling means is not limited to the cooling fan but may be configured such as to set the temperatures of the heaters 2c to 2f within the heating space 2 to gradually lower the temperature toward the outlet side.

In the present invention, in order to find the soldering method that does not warp the cell Ce, in the soldering step of Fig. 1, the photovoltaic cell Ce and the interconnectors Tr are soldered, and the warping of the photovoltaic cell Ce and the soldered state of the interconnectors Tr after soldering are inspected. Soldering is performed as follows. The photovoltaic cell and the interconnectors Tr are positioned on the carrier holders of the embodiments 1-3 of the present invention and the comparative examples 1-6. Then the carrier holders are mounted on the conveyor 1 and passes through the heating space 2. Soldering is completed thereafter. Later described Table 1 is combined results of the embodiments 1 - 3 and the comparative examples 1 - 6 together. In this case, conveyor speed is set to 500 mm/min in both embodiments and comparative examples. Also, the cell Ce employs cells in which each side of the cells is 155 mm and thicknesses thereof are 220 µm and 240 µm, and the interconnector Tr employs an unleaded solder type in the embodiments and the comparative examples as described in Table 1.
Also, the carrier holders 3 - 10 in each embodiment and the comparative example is constituted by the upper holders and the lower holders as shown in the summary configuration in Figs. 2 - 10, and the cell Ce and the interconnectors Tr are held together by both the holders as described above; however, the upper and lower holders are temporarily fixed to each other by a heat resistant tape Ft or the like.

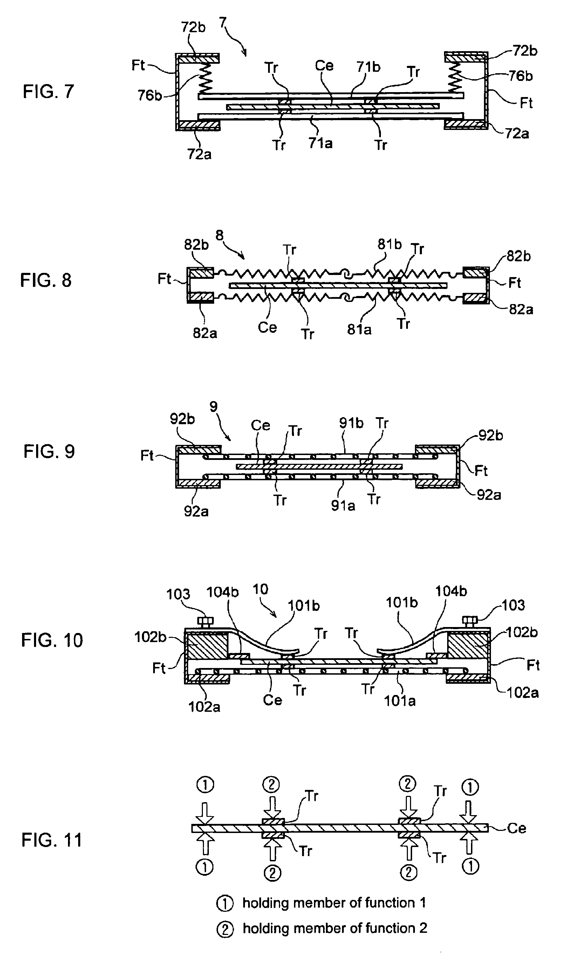

Fig. 11 is a view schematically showing a basic configuration of the soldering method of the present invention.
In order to hold the photovoltaic cell Ce and the interconnectors Tr together, the carrier holder is constructed by members having the following two functions, and the soldering is carried out. Function 1: preventing the warp of the cell Ce after being soldered. Function 2: tightly holding the interconnectors Tr against the cell Ce. According to the method of the present invention, the member holding the cell Ce in the lower surface side and the upper surface side thereof may employ a method of independently providing the function 1 and the function 2 mentioned above or may be constituted by a holding member having both function 1 and function 2. The configuration of the carrier holder holding the cell Ce and the interconnectors Tr in the embodiments of the present invention is explained below in detail.

[Embodiment 1] Embodiment 1 of the carrier holder 3 of the photovoltaic cell Ce with the interconnectors Tr arranged at the predetermined position is as shown in Fig. 2. The carrier holder 3 is configured as follows. That is, in Fig. 2, a cell support body 3a almost entirely supports the photovoltaic cell Ce from a back surface (a lower surface), and a surface-shaped support body 3b holds in such a manner as to press the photovoltaic cell Ce and the interconnectors Tr from above of the interconnectors Tr arranged in the cell Ce supported by the support body 3a from below. In this case, the upper and lower support bodies 3a and 3b are made of elastic heat resistant resin, and a portion adjacent to an end side parallel to the interconnectors Tr in the cell Ce can be held flat by fixing the end portions of both support bodies 3a and 3b by a heat resistant tape Ft (not shown in Fig. 2).

The cell support bodies 3a and 3b exemplified in Fig. 2 may be formed as a plate shape or may be constructed by a heat resistant net body, a grid body or the like so that the heating effect of the heating portion, constituted by each heaters 2c to 2f, can easily affect to the cell Ce and the interconnectors Tr.
In Fig. 2, the interconnectors are arranged at an upper side against the cell Ce; however, there is a case that the interconnectors are arranged at both surfaces in the upper side and the lower side. Even in the above-situation, the cell Ce can be held flat, and the interconnectors Tr can be held tightly against the cell Ce.

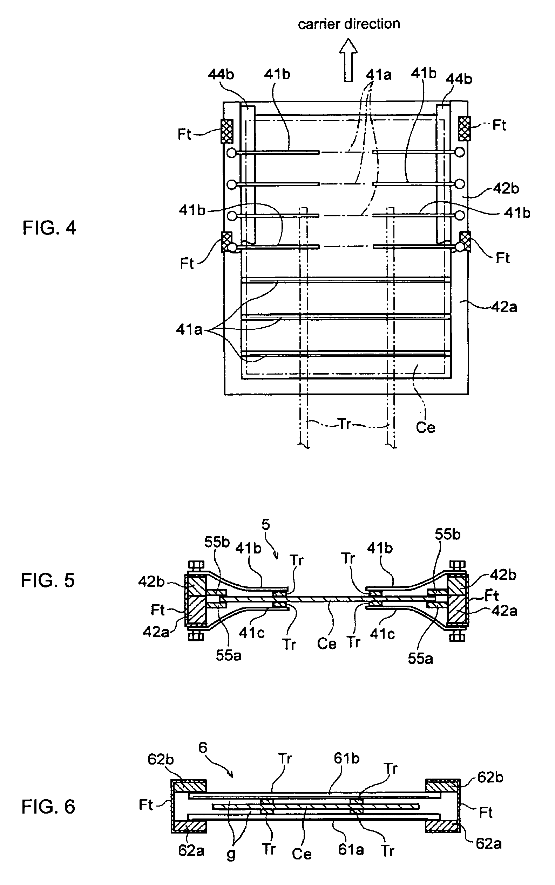

[Embodiment 2] Figs. 3 and 4 show embodiment 2 of the carrier holder of the cell Ce with the interconnectors Tr soldered thereto. In this embodiment, the carrier holder 4 is configured as follows. The lower surface of the cell Ce is constructed by attaching a plurality of round rod shaped support crosspieces 41a, which are orthogonal to the carrier direction of the cell Ce, in almost equal pitches, in an approximately rectangular frame 42a ample enough for the cell Ce to fit therein as seen from (with reference to) the plan view of Fig. 4. On the other hand, a press plate of the interconnector is constructed by installing a plurality of almost fork claw shaped or stick shaped elastic press bars 41b to an almost rectangular press frame 42b that is ample enough for the cell Ce to fit therein as seen from (with reference to) the plan view of Fig. 4, and an upper surface of the cell Ce is configured such as to press both side-edges by the press plate 44b. In addition, an attaching screw 43 is for attaching and detaching the press bar 41b. Figs. 3 and 4 show a state in which the interconnectors Tr are arranged in the upper side against the cell Ce; however, there is a case that the interconnectors Tr are arranged at both surfaces at the upper side and the lower side of the cell Ce. As such, an interval between the press plate 44b and the support crosspiece 41a is provided with a clearance corresponding to the thickness of the interconnector Tr at the lower side. In this case, the cell Ce is warped at the thickness of the interconnector Tr arranged in the lower side so as to be held. However, since the thickness of the interconnector Tr is about approximately 0.2 to 0.3 mm, any crack is not generated in the cell Ce. The upper carrier holder and the lower carrier holder having the above-configurations are fixed by the heat resistant tape Ft, and the cell Ce is held flat, so that the interconnectors Tr are tightly held against the cell Ce.

[Embodiment 3] Embodiment 3 of the carrier holder of the cell Ce to which the interconnectors Tr are soldered is as shown in Fig. 5. The holder 5 of this embodiment is configured as follows. That is, instead of the round rod shaped support crosspieces 41a which are orthogonal to the carrier direction in the lower surface side of the cell Ce in Figs. 3 and 4, the holder 5 uses a plurality of press bars 41c formed approximately as an elastic fork claw shape or a stick shape used for pressing the interconnectors in Figs. 3 and 4. A flat holding mechanism of the cell Ce in this case is configured such as to arrange press plate 55b having the same aspect as the press plate 44b used in Figs. 3 and 4 in the upper portions of both side-edges of the cell Ce, to arrange the support bodies 55a having the same shape as the press plate 55b in the lower portions of both side-edges, and to hold the cell Ce flat in the upper and lower surfaces of the cell Ce. According to the carrier holder 5 having the above-described configuration, the interconnectors Tr may be arranged at the upper side and the lower side of the cell Ce as shown in Fig. 5, or the interconnectors Tr may be arranged in any one surface against the cell Ce. The cell Ce is flatly held by fixing the upper carrier holder and the lower carrier holder having the above-described configuration by the heat resistant tape Ft or the like, and the interconnectors Tr are tightly held against the cell Ce.

In the present invention, the soldering steps of the interconnectors Tr to the cell Ce is executed by causing the carrier holders 3 to 5 exemplified in Figs. 2 and 3, Fig. 4 and Fig. 5 to hold the interconnectors Tr and the cell Ce together arranging the interconnectors Tr at the predetermined position and passing the holders 3 to 5 through the inner portion of the heating space 2 while carrying the holders 3 to 5 by the carrier conveyor 1. As such, while the cell Ce and the interconnectors Tr pass through the inner portion of the heating space 2, the cell Ce is flatly held by the upper and lower support bodies 3a and 3b (refer to Fig. 2), the support crosspiece 41a and the press plate 44b (refer to Figs. 3 and 4) or the support body 55a and the press plate 55b (refer to Fig. 5).
Also, the cell Ce and the interconnectors Tr are set to the tightly held state by the upper and lower support bodies 3a and 3b (refer to Fig. 2), the support crosspiece 41a and the press bar 41b provided in the frames 42a and 42b (refer to Figs. 3 and 4), and the upper and lower press bars 41c and 41b (refer to Fig. 5).
The above-described holding method of the cell Ce and the interconnectors Tr at the time of soldering the cell Ce is arranged to achieve a good result with no warping of the cell Ce after being soldered as shown in Table 1 and no unevenness in welding of the soldering in the embodiments 1 to 3.

Next, the comparative examples are used to explain the effectiveness of the embodiments of the present invention is such that the method of the present invention can remove the warp and unevenness in welding in the soldering between the photovoltaic cell Ce and the interconnectors Tr.
Also, in the comparative examples, the interconnectors Tr are arranged at the upper side and the lower side of the cell Ce.

### [Comparative Example 1]

The carrier holder 6 of the comparative example 1 is configured as shown in Fig. 6.
A support of the lower surface of the cell Ce is constructed by attaching a plurality of round rod shaped support crosspieces 61a, which are orthogonal to the cell carrier direction, in almost equal pitches, to an approximately rectangular frame 62a ample enough for the cell Ce to fit therein as seen from (with reference to) the plan view of Fig. 4.
On the other hand, the press of the cell Ce and the interconnectors Tr from above is constructed by attaching a plurality of round rod shaped press bars 61b, which are orthogonal to the cell carrier direction, in almost equal pitches, to the approximately rectangular frame 62b ample enough for the cell Ce to fit therein as seen from (with reference to) the plan view of Fig. 4 in the same manner as the press of the lower surface of the cell Ce.
According to this configuration, a gap g is generated at the thickness of the interconnectors Tr between the cell Ce and the support crosspiece 61a on the one hand, and between the cell Ce and the press bar 61b on the other hand. The upper carrier holder and the lower carrier holder with the above-described configurations are fixed by the heat resistant tape Ft or the like. The cell Ce and the interconnectors Tr all together (in Fig. 6) are held together by the round rod shaped support crosspiece 61a and the press bar 61b. Then, the carrier holder, with the cell Ce and the interconnectors Tr installed thereon, is mounted on the conveyor 1 and passes through the heating space 2 to be soldered.
In the condition of the soldering between the cell Ce and the interconnectors Tr after being soldered, since the right and left side-edges of the cell Ce are not flatly held, the warp is resulted as described in Table 1.

### [Comparative Example 2]

The carrier holder 7 of the comparative example 2 is configured as shown in Fig. 7.
That is, a support of the lower surface of the cell Ce is constructed by attaching a plurality of round rod shaped support crosspieces 71a, which are orthogonal to the cell carrier direction, in almost equal pitches, to an approximately rectangular frame 72a ample enough for the cell Ce to fit therein as seen from (with reference to) the plan view of Fig. 4.
On the other hand, the pressing the cell Ce and the interconnectors from above is constructed by arranging a plurality of round rod shaped press bars 71b which are orthogonal to the cell carrier direction. Each round rod shaped press bars 71b is configured such that a spring 76b is connected to both ends thereof and are attached in almost equal pitches to an approximately rectangular frame 72b ample enough for the cell Ce to fit therein as seen from (with reference to) the plan view of Fig. 4.
The upper carrier holder and the lower carrier holder with the above-described configurations are fixed by the heat resistant tape Ft. The cell Ce and the interconnectors Tr all together (in Fig. 7) are held together by the round rod shaped support crosspiece 71a and the press bar 71b via a force of a spring 76b. Then, the carrier holder, with the cell Ce and the interconnectors Tr installed thereon, is mounted on the conveyor 1 and passes through the heating space 2 to be soldered.
In the condition of the soldering between the cell Ce and the interconnectors Tr, unevenness in welding of the soldering after being soldered appeared as described in Table 1 depending upon the existence of the press bar 71b and its expanded spring.

### [Comparative Example 3]

The carrier holder 8 of the comparative example 3 is configured as shown in Fig. 8.
That is, a support of the lower surface of the cell Ce is constructed by attaching a plurality of the springs 81a, which are orthogonal to the cell carrier direction, in almost equal pitches, to an approximately rectangular frame 82a ample enough for the cell Ce to fit therein as seen from (with reference to) the plan view of Fig. 4.
On the other hand, the pressing the cell Ce and the interconnectors Tr from above is constructed by attaching a plurality of springs 81b, which are orthogonal to the cell carrier direction, in almost equal pitches, to the approximately rectangular frame 82b ample enough for the cell Ce to fit therein as seen from (with reference to) the plan view of Fig. 4.
The upper carrier holder and the lower carrier holder with the above-described configurations are fixed by the heat resistant tape Ft or the like. The cell Ce and the interconnectors Tr all together (in Fig. 8) are held together by the extended springs 81a and 81b. Then, the carrier holder, with the cell Ce and the interconnectors Tr installed thereon, is mounted on the conveyor 1 and passes through the heating space 2 to be soldered.
In the condition of the soldering between the cell Ce and the interconnectors Tr, many portions with attachment defect after being soldered appeared as described in Table 1.
This is believed to occur because the tight holding degree between the cell Ce and the interconnectors Tr fall short because of an insufficient holding force generated by the springs 81a and 81b in the horizontal position.

### [Comparative Example 4]

The carrier holder 9 of the comparative example 4 is configured as shown in Fig. 9.
That is, the support of the lower surface of the cell Ce is constructed by arranging a metal net-shaped or grid-shaped support body 91a having a heat resistance in an approximately rectangular frame 92a ample enough for the cell Ce to fit as seen from (with reference to) the plan view of Fig. 4.
On the other hand, the pressing the cell Ce and the interconnectors Tr from above is constructed by arranging a metal net-shaped or grid-shaped press body 91b having a heat resistance in the same manner as the lower surface of the cell Ce in an approximately rectangular frame 92b ample enough for the cell Ce to fit therein as seen from (with reference to) the plan view of Fig. 4. The upper carrier holder and the lower carrier holder with the above-described configurations are fixed by the heat resistant tape Ft or the like. The cell Ce and the interconnectors Tr all together (in Fig. 9) are held together by the metal net-shaped or grid-shaped support body 91a and the press body 91b. The carrier holder, with the cell Ce and the interconnectors Tr installed thereon, is mounted on the conveyor 1 and passes through the heating space 2 to be soldered.
In the condition of the soldering between the cell Ce and the interconnectors Tr, uneven welding appeared in addition to the large warp after being soldered, as described in Table 1. This is because the right and left side-edges of the cell Ce are not flatly held, and the pressing force for tightly holding the interconnectors Tr against the cell surface becomes insufficient.

### [Comparative Example 5]

Comparative example 5 is not illustrated in the figures. Although it is not shown in the figures, the carrier holder described hereinbelow is used in this example. The carrier holder 9, which is the same as the comparative example 4, is used to press each side of frames 92a and 92b of the support body 91a and the pressing body 91b by the heat resistant tape Ft to mount a weight (not shown in the figures) to the center portion of the net-shaped or grid-shaped body 91b, thereby holding the cell Ce and the interconnectors Tr together. Thereafter, the soldering is carried out by mounting the carrier holder 9 on the conveyor 1 so as to travel within the heating space 2.
In the condition of the soldering between the cell Ce and the interconnectors Tr, uneven welding appeared after being soldered, as described in the Table 1. This is because the tightly holding degree between the interconnectors Tr and the cell Ce becomes insufficient.

### [Comparative Example 6]

The carrier holder 10 of the comparative example 6 is configured as shown in Fig. 10.
That is, the support of the lower surface of the cell Ce is constructed, in the same manner as the comparative example 4, by arranging a metal net-shaped or grid-shaped support body 101a having a heat resistance in an approximately rectangular frame 102a ample enough for the cell Ce to fit as seen from (with reference to) the plan view of Fig. 4.
On the other hand, the pressing cell Ce and the interconnectors from above is constructed by arranging a plurality of an almost fork claw shape or stick shape elastic press bar 101b to the frame 102b in the same manner as the embodiment 2.
In addition, the upper surface of the cell Ce is constructed by pressing both side-edges thereof by a press plate 104b. In addition, an attaching screw 103 is to attach and detach the press bar 101b.
The upper carrier holder and the lower carrier holder with the above-described configurations are fixed by the heat resistant tape Ft or the like. The cell Ce and the interconnectors Tr all together (in Fig. 10) are held together by the net-shaped or grid-shaped support body 101a and the elastic press bar 101b. The carrier holder, with the cell Ce and the interconnectors Tr installed thereon, is mounted on the conveyor 1 and passes through the heating space 2 to be soldered.
In the condition of the soldering between the cell Ce and the interconnectors Tr, the warp after being soldered appeared as described in the Table 1. This is because the lower surface support of the cell Ce cannot smoothly support an expansion and contraction strain in the soldering processing of the cell Ce, and a residual heat strain results in the large warp.

**Table 1**

| | Cell thickness/kind of interconnector | carrier holder for soldering | | | | condition of soldering and warp of cell after being soldered |
|---|---|---|---|---|---|---|
| | | upper side | lower side | method of holding upper and lower sides together | complement | |
| Embodiment 1 | 220/B | Plate shape in whole surface | Plate shape in whole surface | heat resistant tape | | good |
| Embodiment 2 | 220/B | fork shaped press bar | Support crosspiece (round rod) | heat resistant tape | | good |
| Embodiment 3 | 240/B | fork shaped press bar | fork shaped press bar | heat resistant tape | | good |
| Comparative Example 1 | 240/B | press bar (round rod) | support crosspiece (round rod) | heat resistant tape | with gap | with warp |
| Comparative Example 2 | 240/B | spring type press bar (round rod) | support crosspiece (round rod) | heat resistant tape | | unevenness in welding |
| Comparative Example 3 | 240/B | transversal spring | transversal spring | heat resistant tape | | many unattached portions (defective in no-spring portion) |
| Comparative Example 4 | 240/B | net-shaped press body | net-shaped support body | heat resistant tape | | unattached except both ends, great warp |
| Comparative Example 5 | 240/B | net-shaped press body | net-shaped support body | heat resistant tape + weight | | with unevenness in welding |
| Comparative Example 6 | 240/B | fork shaped press bar | net-shaped support body | heat resistant tape | | with warp |

| | | | | | | |
|---|---|---|---|---|---|---|
| cell 240 = thickness µm 220 = thickness µm interconnector B = lead free solder (unleaded) CV speed (mm/min) = 500 in all with gap: gap is partly generated since the lower side is constituted by bar press: cell end portion is pressed by tape weight: since stainless net is warped, the net is pressed by weight from the above | | | | | | |

The above-description is made for the case that the interconnectors Tr are tightly held against the cell Ce by utilizing the elasticity of the press bar provided in the carrier holders 3 to 5 shown in Figs. 2 to 5.
In addition to the case that the interconnectors Tr is actively pressed to tightly hold the interconnectors Tr against the cell Ce, the present invention may have the configuration whereby the holding condition is such that the press force is approximately zero by selecting the holding intervals of the interconnectors Tr by the press bar in order to hold the interconnectors Tr as abutting against the cell Ce.

The soldering method of the photovoltaic cell and the interconnector of the present invention is configured as follows.
1) The soldering method comprises the steps of: positioning the interconnector at the predetermined position of the photovoltaic cell at the time of soldering the interconnector to the photovoltaic cell; setting the cell under the heating atmosphere in which the solder is dissolved in that state so as to hold the cell flat while heating entirely; and simultaneously holding the interconnector and the photovoltaic cell tightly.
2) The interconnector positioned at the predetermined position of the photovoltaic cell is soldered by dissolving the solder while entirely heating the photovoltaic cell under the heating atmosphere and thereafter slowly cooling the photovoltaic cell.
Accordingly, even if the deformation caused by the different expansion and contraction is generated in the cell and the interconnector having the different coefficients of thermal expansion due to the heating and the cooling of the soldering step, the entire cell and interconnector are constrained flat and are tightly held, so that it is possible to achieve the specific effect whereby there is no resultant warp in the cell during soldering and at the room temperature after the end of the soldering.
Further, since the photovoltaic cell is cooled slowly after entirely heating the photovoltaic cell under the heating atmosphere so as to dissolve the solder, the interconnector moves within the dissolving solder at a time as the solder solidifis, and therefore it is possible to effectively prevent the deformation (the warp) caused by the heat strain due to the difference of coefficient of thermal expansion between the photovoltaic cell and the interconnector and the temperature distribution thereof.

Accordingly, the method of the present invention is extremely useful as the soldering method of the interconnector at the time of processing the photovoltaic module without resulting in the warp in the thin photovoltaic cell which is increased in recent years.

### [Description of Reference Numbers]

1. carrier conveyor in soldering step,
2. heating space for soldering,
3. carrier holder of photovoltaic cell in which interconnectors are arranged in the embodiment 1,
4. carrier holder of photovoltaic cell in which interconnectors are arranged in the embodiment 2,
5. carrier holder of photovoltaic cell in which interconnectors are arranged in the embodiment 3,
6. carrier holder of photovoltaic cell in which interconnectors are arranged in the comparative example 1,
7. carrier holder of photovoltaic cell in which interconnectors are arranged in the comparative example 2,
8. carrier holder of photovoltaic cell in which interconnectors are arranged in the comparative example 3,
9. carrier holder of photovoltaic cell in which interconnectors are arranged in the comparative example 4,
10. carrier holder of photovoltaic cell in which interconnectors are arranged in the comparative example 6,
2c - 2f. heater,
3a. support body (lower surface side),
3b. support body (upper surface side),
41a. support crosspiece,
41b. elastic press bar,
42a, 42b. frame,
43. attaching screw,
44b. press plate,
55a. support body,
55b. press plate,
61a. support crosspiece,
61b. press bar,
62a, 62b. frame,
71a. support crosspiece,
71b. press bar,
72a, 72b. frame,
76b. spring,
81a, 81b. spring,
82a, 82b. frame,
91a. net-shaped or grid-shaped support body,
91b. net-shaped or grid-shaped press body,
92a, 92b. frame,
101a. net-shaped or grid-shaped support body,
101b. elastic press bar,
102a, 102b. frame,
103. attaching screw,
104b. press plate, Ce. Photovoltaic cell, Tr. Interconnector

## Claims

1. A method for soldering an interconnector to a photovoltaic cell, comprising steps of: positioning the interconnector at a predetermined position on the photovoltaic cell; setting the photovoltaic cell with the positioned interconnector under heating atmosphere in which solder is dissolved so as to hold the photovoltaic cell flat; and simultaneously holding the interconnector and the photovoltaic cell tightly.

2. A method for soldering an interconnector to a photovoltaic cell, comprising steps of:
positioning the interconnector to the photovoltaic cell so as to be held flat; and
soldering the interconnector to the photovoltaic cell by setting the interconnector positioned on the photovoltaic cell, while the interconnector is being held at the photovoltaic cell, under heating atmosphere capable of dissolving the solder, heating the interconnector and the photovoltaic cell entirely, and tightly holding the interconnector to the photovoltaic cell..

3. The method for soldering an interconnector to a photovoltaic cell according to claim 1 or 2**, characterized in that** the photovoltaic cell is slowly cooled after dissolving the solder while entirely heating the photovoltaic cell under the heating atmosphere.

4. The method of soldering an interconnector to a photovoltaic cell according to any one of claims 1 to 3, **characterized in that** the retention of the interconnector to be soldered is supported by pressing to the photovoltaic cell side at a plurality of points on the interconnector.

5. The method for soldering an interconnector to a photovoltaic cell according to any one of claims 1 to 3, **characterized in that** the pressing and supporting means at a plurality of points of the interconnector is constituted by an elastic stick-shaped member.

6. The method for soldering an interconnector to a photovoltaic cell according to any one of claims 1 to 5, **characterized in that** the photovoltaic cell to be under the heating atmosphere is held by a carrier holder, and the photovoltaic cell is constrained and held flat at least in a direction extending along the interconnector to be soldered on the carrier holder.

7. The method for soldering an interconnector to a photovoltaic cell according to any one of claims 1 to 5, **characterized in that** the photovoltaic cell to be under the heating atmosphere is held by a carrier holder, and the photovoltaic cell is constrained and held flat from both surfaces at least both side-edges extending along the interconnector to be soldered on the carrier holder.

8. The method for soldering an interconnector to a photovoltaic cell according to claim 6 or 7, **characterized in that** the photovoltaic cell to be under the heating atmosphere is supported by a surface-shaped member or a crosspiece-shaped member in a lower surface of the cell on the carrier holder of the photovoltaic cell.
